(19) **Europäisches Patentamt European Patent Office Office européen des brevets**

(11) **EP 3 807 937 B1**

(12) **EUROPEAN PATENT SPECIFICATION**

(45) Date of publication and mention of the grant of the patent:
**29.03.2023 Bulletin 2023/13**

(51) International Patent Classification (IPC):
*H01P 1/15* (2006.01)    *H01P 1/203* (2006.01)
*H03K 17/74* (2006.01)    *H03K 17/78* (2006.01)
*H01L 31/09* (2006.01)

(21) Application number: **19826407.9**

(22) Date of filing: **27.06.2019**

(52) Cooperative Patent Classification (CPC):
**H03K 17/78; H01L 31/09; H01P 1/15; H01P 1/2039; H03K 17/74**

(86) International application number:
**PCT/KR2019/007838**

(87) International publication number:
**WO 2020/004991 (02.01.2020 Gazette 2020/01)**

(54) **HIGH FREQUENCY SWITCH FOR HIGH FREQUENCY SIGNAL TRANSMITTING/RECEIVING DEVICES**

HOCHFREQUENZSCHALTER FÜR HOCHFREQUENZ-SIGNALSENDE-/EMPFANGSVORRICHTUNGEN

COMMUTATEUR HAUTE FRÉQUENCE POUR DISPOSITIFS D'ÉMISSION/RÉCEPTION DE SIGNAUX HAUTE FRÉQUENCE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.06.2018 RU 2018123298**
**22.03.2019 KR 20190033201**

(43) Date of publication of application:
**21.04.2021 Bulletin 2021/16**

(73) Proprietor: **Samsung Electronics Co., Ltd.**
**Suwon-si, Gyeonggi-do 16677 (KR)**

(72) Inventors:
• **LUKYANOV, Anton Sergeevich**
**Moscow, 127349 (RU)**
• **SHEPELEVA, Elena Aleksandrovna**
**Kostroma, 156000 (RU)**
• **NIKISHOV, Artem Yurievich**
**Moscow Region, 140404 (RU)**
• **EVTYUSHKIN, Gennadiy Aleksandrovich**
**Moscow, 129347 (RU)**
• **MAKURIN, Mikhail Nikolaevich**
**Arkhangelsk, 163000 (RU)**
• **KIM, Kisoo**
**Suwon-si, Gyeonggi-do 16677 (KR)**

• **YANG, Dongil**
**Suwon-si, Gyeonggi-do 16677 (KR)**
• **LEE, Jongin**
**Suwon-si, Gyeonggi-do 16677 (KR)**

(74) Representative: **Walaski, Jan Filip et al**
**Venner Shipley LLP**
**200 Aldersgate**
**London EC1A 4HD (GB)**

(56) References cited:
**WO-A1-2012/115333    US-A1- 2007 092 812**
**US-A1- 2007 257 256    US-A1- 2007 290 774**
**US-A1- 2009 009 853**

• **Pang Alexander Weiran ET AL: "An Optically Controlled Coplanar Waveguide Millimeter-Wave Switch", , 13 June 2018 (2018-06-13), pages 1-4, XP055820048, Retrieved from the Internet: URL:https://research-information.bris.ac.u k/ws/portalfiles/portal/181546886/Martin_C ryan_An_Optically_Controlled_Co_Planar_Wav eguide_Millimetre_Wave_Switch.pdf [retrieved on 2021-07-01]**

- FLEMISH J R ET AL: "Optimization of a Photonically Controlled Microwave Switch and Attenuator", IEEE TRANSACTIONS ON MICROWAVE THEORY AND TECHNIQUES, PLENUM, USA, vol. 58, no. 10, 1 October 2010 (2010-10-01), pages 2582-2588, XP011318502, ISSN: 0018-9480
- AVANISH BHADAURIA ET AL: "Optical control of microstrip stub on silicon substrate using 650 nm and 850 nm wavelengths illumination", MICROWAVE PHOTONICS, 2008. JOINTLY HELD WITH THE 2008 ASIA-PACIFIC MICROWAVE PHOTONICS CONFERENCE. MWP/APMP 2008. INTERNATIONAL TOPICSL MEETING ON, IEEE, PISCATAWAY, NJ, USA, 9 September 2008 (2008-09-09), pages 138-141, XP031358056, ISBN: 978-1-4244-2168-8

## Description

## Technical Field

The disclosure relates generally to switches, and more particularly, to optically controlled switches for high-frequency signal transmitting/receiving devices with very high operating frequencies.

## Background Art

A rapid growth in communication technologies is predicated upon the continuous evolution of user's needs. Currently, fifth generation partnership project (5G) millimeter wave (mmWave) networks are under development, which will exhibit higher performance in the user experience, including such factors as high transmission rate and power usage efficiency. 5G networks and car navigation sensors can change the scenario of wireless systems.

New mmWave applications require the introduction of a new class of circuits that can integrate data transmission and detection abilities in a single wireless device. Among the available technologies, an important role is played by devices implemented on printed circuit boards (PCBs), as they are simple in design and manufacture, can be economically integrated into a single dielectric substrate, have a suitable base for broadband implementation, and are easily combined with traditional PCB technologies.

Currently, PIN diodes, metal oxide semiconductor field effect transistor (MOSFET) devices, and microelectromechanical systems (MEMS) are used as switching components in high frequency circuits. However, PIN diodes have a complex bias circuit (switching from positive current source to negative voltage), a MOSFET has high parasitic capacitance in low channel resistance, and a MEMS has a finite number of switching cycles and high control voltage.

As such, the existing switching technologies for high-frequency signal transmitting/ receiving devices (keys, switches, phase shifters) are very sophisticated and therefore expensive, especially for frequencies over 10 GHz since they require miniaturization, cause radio frequency (RF) loss to be experienced due to intersection of RF channels with bias and DC supply circuits, are highly complex in terms of bias and supply circuits and occupy an excessive PCB area with bulky components, rendering integration into compact devices difficult.

The above problems can be overcome by an optically controlled component with a bias circuit galvanically isolated from an RF channel. In this case, a "decoupled" RF channel is provided. Therefore, additional frequency filtering circuits, which are required with conventional components, can be omitted.

Principle of operation of the optically controlled components is based on the photoconductivity effect, i.e. the ability of a semiconductor material to change its electrical characteristics by switching from a dielectric to conductive state depending on lighting. For example, a conventional photoconductive switch module provides a specific layer guiding light from light-emitting elements to photoconductive elements. However, the switching module has a bulky construction and consumes excessive power for lighting.

Furthermore, a photoconductive switch includes a photoconductive material and first and second contacts provided on said photoconductive material, wherein said first and second contacts comprise a plurality of interdigitated tracks that are separated from the tracks of the other contact by a photoconductive gap and are curved such that the minimum photoconductive gap measured in a first direction remains substantially similar regardless of the orientation of the first direction. A disadvantage of the switch, however, is the parasitic capacitance causing additional wave leaking and lower isolation. In addition, the switch is not suitable for complete blocking of mmWaves.

A microstrip diode high isolation switch is based on PIN diodes realizing a resultant obstacle into a broadband resonant circuit which may be switched between two states . When the diode is not conducting, the obstacle appears as an open circuit. However, in the Hallford switch the RF path circuits are disadvantageously coupled with bias and supply circuits of the PIN diodes, and the structure is rather bulky.

A microstrip single pole double throw switch incorporating multiple MEMS contacts includes first pair of contacts is located adjacent to the junction of input and output lines for optimization of performance bandwidth. The MEMS contacts that are not located adjacent to the junction are spaced along the output lines to further optimize the bandwidth and isolation in the OFF state, while minimizing insertion loss in the ON state. However, the switch is a complicated arrangement of bias and supply circuits, and is expensive and difficult to manufacture for high frequency applications.

Other microstrip radio frequency switches are based on a photoconductive switching element, which is series mounted in a microstrip line, such as in a stripline gap. In these switches, electric current is concentrated near semiconductor edges where electrical conductivity is low due to edge effects and respective surface recombination of carriers at the edges, while minimum current density is observed at the center of the microstrip where surface recombination is lower since it is technologically feasible to provide good surface quality of semiconductor material wafers from which these elements are made. As a consequence, high losses occur when electric current passes through the poorly conducting sections of the switch, and the switch requires a high optical power to switch to the ON state. In addition, the switch has a low blocking level due to parasitic capacitance.

"An Optically Controlled Co-Planar Waveguide Millimetre Wave Switch", Pang Alexander Weiran et al., discusses difficulties in implementing an optically controlled CPW switch at very high frequencies.

"Optimization of a Photonically Controlled Microwave Switch and Attenuator", Flemish J R et al., relates to a photoconductive switch and attenuator for microwave signals optimised for low insertion loss and high attenuation response upon illumination.

"Optical Control of Microstrip Stub on Silicon Substrate Using 650 nm and 850 nm Wavelengths Illumination", Avanish Bhadauria et al., demonstrates optical control of an RF signal through a microstrip-based stub structure having a length of $\lambda/4$.

Therefore, there is a need in the art to provide optically controlled switches for high-frequency signal transmitting/receiving devices with very high operating frequencies (up to about 100 GHz), which would simultaneously have low losses, low control power, a small size, and a simple supply/bias circuit to avoid spurious effects and low cost.

**Disclosure of Invention**

**Technical Problem**

An aspect of the disclosure is to address at least the above-mentioned problems and/or disadvantages and to provide at least the advantages described below. Accordingly, an aspect of the disclosure is to provide a high frequency switch having an improved blocking characteristic.

Another aspect of the disclosure is to provide is a high frequency switch requiring low-power.

**Solution to Problem**

According to an aspect of the present invention, there is provided a high frequency switch comprising the features of claim 1.

**Advantageous Effects of Invention**

The disclosure may provide the high frequency switch using the photoconductive semiconductor element having conductivity adjusted by control light.

**Brief Description of Drawings**

The above and other aspects, features, and advantages of certain embodiments of the disclosure will be more apparent from the following description taken in conjunction with the accompanying drawings, in which:

FIG. 1 illustrates a high frequency switch according to an embodiment;
FIG. 2A is a plan view of FIG. 1;
FIG. 2B is a cross-sectional view taken along line I-I' of FIG. 1;
FIG. 3 illustrates an OFF state of the high frequency switch of FIGS. 1, 2A and 2B;

FIG. 4 is a cross-sectional view taken along line I-I' of FIG. 3;
FIG. 5 is an equivalent circuit of FIG. 3;
FIG. 6 illustrates an ON state of the high frequency switch of FIGS. 1, 2A and 2B;
FIG. 7 is a cross-sectional view taken along line I-I' of FIG. 6;
FIG. 8 is an equivalent circuit of FIG. 6;
FIG. 9 illustrates a simulation result of an operation of the high frequency switch of FIGS. 1, 2A and 2B;
FIG. 10 illustrates a high frequency switch according to an embodiment;
FIG. 11 is a plan view of FIG. 10;
FIG. 12 is an equivalent circuit of a high frequency switch in an ON state;
FIG. 13 illustrates the simulation result of the operation of the high frequency switch described with reference to FIGS. 1, 2A and 2B and a simulation result of an operation of the high frequency switch described with reference to FIGS. 10 and 11;
FIG. 14 illustrates a high frequency switch according to an embodiment;
FIG. 15 is a plan view of FIG. 14;
FIG. 16 is an equivalent circuit of the high frequency switch of FIG. 14 in an OFF state;
FIG. 17 is an equivalent circuit of the high frequency switch of FIG. 14 in an ON state;
FIG. 18 illustrates simulation results of operations of a high frequency switch according to frequencies;
FIG. 19 illustrates a high frequency switch according to an embodiment;
FIG. 20 is a cross-sectional view of a high frequency switch according to an embodiment, which corresponds to line I-I' of FIG. 1;
FIG. 21 is a cross-sectional view of a high frequency switch according to an embodiment, which corresponds to line I-I' of FIG. 1;
FIG. 22 is a plan view of a high frequency switch according to an embodiment;
FIG. 23 is a plan view of a high frequency switch according to an embodiment; and
FIG. 24 is a cross-sectional view of a high frequency switch which corresponds to line I-I' of FIG. 1, according to an embodiment. The embodiments associated with FIGs. 1-13 and 17-24 are not encompassed by the wording of claim 1, but are considered useful for understanding the invention and illustrate the addition of optional features as defined in the dependent claims.

**Best Mode for Carrying out the Invention**

In accordance with an aspect of the disclosure, a high frequency switch includes a substrate, a pair of ground sections provided on the substrate, a center conductor provided between the pair of ground sections, and a photoconductive semiconductor element provided on the center conductor and extending between the center conductor and the pair of ground sections.

In accordance with an aspect of the disclosure, a high frequency switch includes a pair of ground sections, a center conductor provided between the pair of ground sections, a photoconductive semiconductor element provided on the center conductor and extending between the center conductor and the pair of ground sections, and a light source irradiating control light on the photoconductive semiconductor element.

In accordance with an aspect of the disclosure, a high frequency switch includes a substrate, a photoconductive semiconductor element provided on the substrate, and a coplanar waveguide line provided between the substrate and the photoconductive semiconductor element, wherein, when control light is irradiated on the photoconductive semiconductor element, electromagnetic waves propagated to the coplanar waveguide line are reflected, and wherein, when the control light is blocked from being irradiated on the photoconductive semiconductor element, the electromagnetic waves are passed through the high frequency switch.

**Mode for the Invention**

Hereinafter, embodiments of the disclosure will now be described with reference to accompanying drawings. In the drawings, like reference numerals refer to like elements, and a size of each component may be exaggerated for clarity and convenience. Embodiments of the disclosure described below are only examples and various modifications are possible. Detailed descriptions of known functions and configurations incorporated here will be omitted for the sake of clarity and conciseness.

The term "above" or "on" may denote a component being directly on and in contact with another component or being on (over) yet not in contact with the another component.

A singular expression includes a plural expression unless otherwise specified. When a part "includes" a component", the part may further include another component instead of excluding the other component, unless otherwise specified.

In addition, the term "unit" used herein denotes a unit processing at least one function or operation, and may be implemented by hardware, software, or a combination of hardware and software.

Throughout the disclosure, the expression "at least one of a, b or c" indicates only a, only b, only c, both a and b, both a and c, both b and c, all of a, b, and c, or variations thereof.

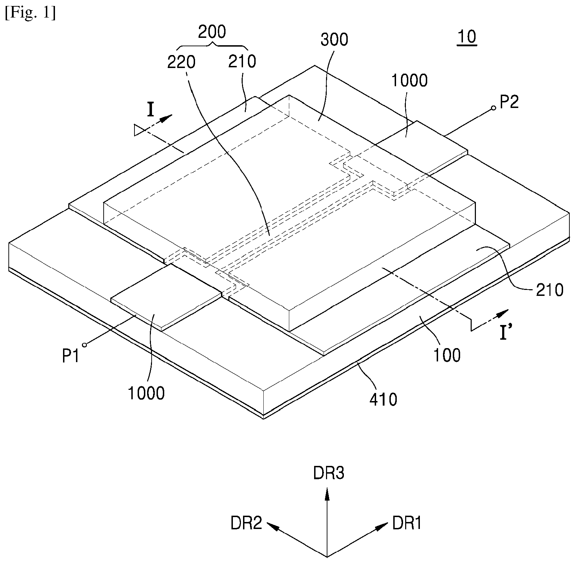

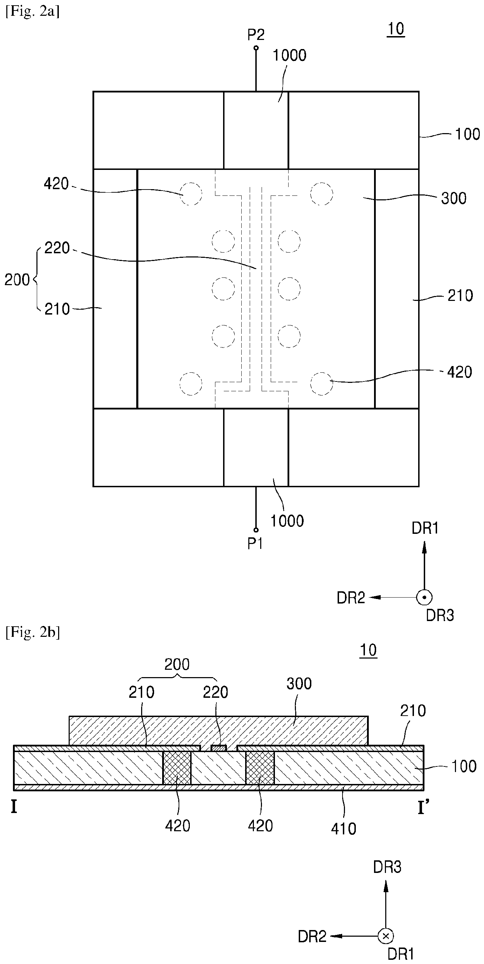

FIG. 1 illustrates a high frequency switch 10 according to an embodiment. FIG. 2A is a plan view of FIG. 1. FIG. 2B is a cross-sectional view taken along line I-I' of FIG. 1.

Referring to FIGS. 1, 2A and 2B, the high frequency switch 10 may include a substrate 100, a coplanar waveguide line 200, and a photoconductive semiconductor element 300. For example, the substrate 100 may include a PCB.

The coplanar waveguide line 200 may include a pair of ground sections 210 and a center conductor 220 between the pair of ground sections 210. The pair of ground sections 210 may extend in a first direction DR1 parallel to a top surface of the substrate 100, may face each other and be spaced apart from each other along a second direction DR2 that is parallel to the top surface of the substrate 100 and crosses the first direction DR1, and may include a conductive material, such as copper (Cu). A ground voltage may be applied to the pair of ground sections 210.

The center conductor 220 may be provided between the pair of ground sections 210. For example, the pair of ground sections 210 may be arranged from side to side on two side surfaces based on the center conductor 220, which may be linear, may extend along the first direction DR1, and may be spaced apart from the pair of ground sections 210 along the second direction DR2.

Distances between the center conductor 220 and the pair of ground sections 210 may be materially identical. The center conductor 220 may overlap the pair of ground sections 210 along the second direction DR2. A width of the center conductor 220 may be greater at both of its end portions than at its center portion, and may be a size of the center conductor 220 along the second direction DR2. The center conductor 220 may include a conductive material, such as Cu, and both end portions of the center conductor 220 may be electrically connected respectively to a pair of signal transmission lines 1000 described later, such as respectively directly contacting the pair of signal transmission lines.

The photoconductive semiconductor element 300 may be provided on the coplanar waveguide line 200, may cover the center conductor 220 and the pair of ground sections 210, may extend between the center conductor 220 and the pair of ground sections 210, may fill regions between the center conductor 220 and the pair of ground sections 210, and may contact the substrate 100 between the center conductor 220 and the pair of ground sections 210.

Conductivity of the photoconductive semiconductor element 300 may be adjusted by control light, and intrinsic electrical conductivity of the photoconductive semiconductor element 300 may be low. For example, the photoconductive semiconductor element 300 may intrinsically have a dielectric state (an OFF state of the high frequency switch 10), in which the photoconductive semiconductor element 300 may electrically disconnect the center conductor 220 and the pair of ground sections 210 from each other. When the control light is irradiated on the photoconductive semiconductor element 300, electrical conductivity of the photoconductive semiconductor element 300 may be increased. For example, when in a conductive state (an ON state of the high frequency switch 10), the photoconductive semiconductor element 300 may electrically connect the center conductor 220

and the pair of ground sections 210 to each other. The photoconductive semiconductor element 300 may include a semiconductor material having conductivity adjusted by the control light, such as silicon (Si), gallium-indium arsenide, or a combination thereof.

A bottom ground layer 410 may be provided opposite to the coplanar waveguide line 200 with the substrate 100 therebetween. The bottom ground layer 410 may cover a bottom surface of the substrate 100. The bottom ground layer 410 may include a conductive material. For example, the lower ground layer 410 may include a metal, such as Cu, and a ground voltage may be applied to the bottom ground layer 410.

Vias 420 may be provided between the pair of ground sections 210 and the bottom ground layer 410 and may electrically connect the pair of ground sections 210 and the bottom ground layer 410 to each other. For example, the vias 420 may directly contact the pair of ground sections 210 and the bottom ground layer 410, may penetrate the substrate 100, may extend along a third direction DR3 perpendicular to the top surface of the substrate 100, and may include a conductive material, such as Cu.

The pair of signal transmission lines 1000 may be provided on the substrate 100, may be spaced apart from each other with the high frequency switch 10 therebetween, and may be respectively electrically connected to both end portions of the center conductor 220. For example, the pair of signal transmission lines 1000 may respectively directly contact the both end portions of the center conductor 220. A width of each of the pair of signal transmission lines 1000 may be materially identical to a width of each of the both end portions of the center conductor 220, and may be greater than a width of a center portion of the center conductor 220. One of the pair of signal transmission lines 1000 may be connected to a first port P1. The other one of the pair of signal transmission lines 1000 may be connected to a second port P2. The pair of signal transmission lines 1000 may include a conductive material, such as Cu.

A size characteristic of the coplanar waveguide line 200 may be determined to provide wave impedance identical to an impedance of the pair of signal transmission lines 1000, such as 50 Ω. For example, the size characteristic of the coplanar waveguide line 200 may include the width of the center conductor 220 and a distance between the center conductor 220 and the pair of ground sections 210. A dielectric constant of the photoconductive semiconductor element 300 may be considered while determining the size characteristic of the coplanar waveguide line 200. The pair of signal transmission lines 1000 and the high frequency switch 10 may be identical. As a result, when the high frequency switch 10 is in the OFF state, electromagnetic wave (signal) may propagate with minimal loss.

The disclosure may provide the high frequency switch 10 using the photoconductive semiconductor element 300 having conductivity adjusted by control light.

The high frequency switch 10 may include a minimal number of components. Accordingly, complexity, size, manufacturing costs, and power consumption of the high frequency switch 10 may be decreased. The high frequency switch 10 may be used in a wide frequency range (maximum 100 GHz) and may have low mmWave loss. The first and second ports P1 and P2 may be electrically disconnected from supply/bias circuits of the high frequency switch 10, which may have a high blocking performance.

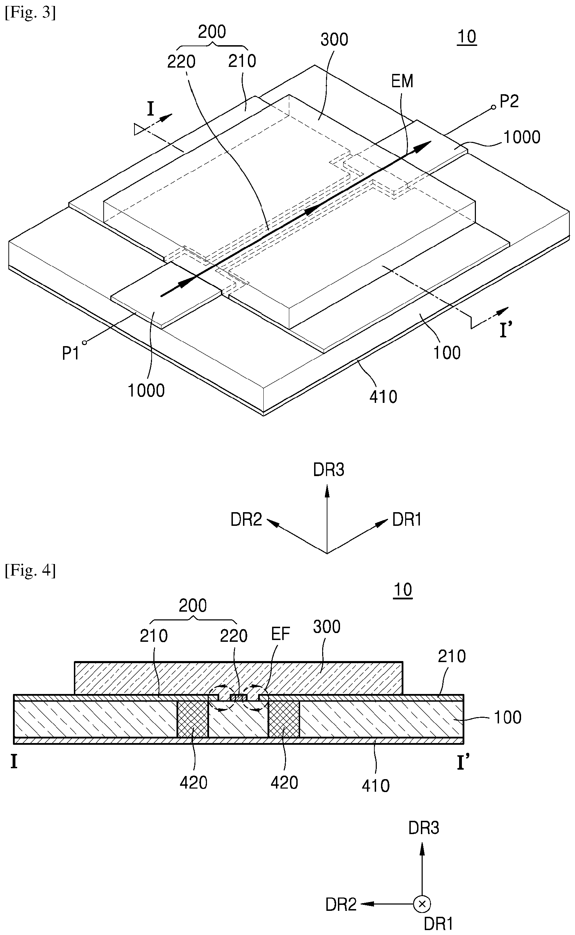

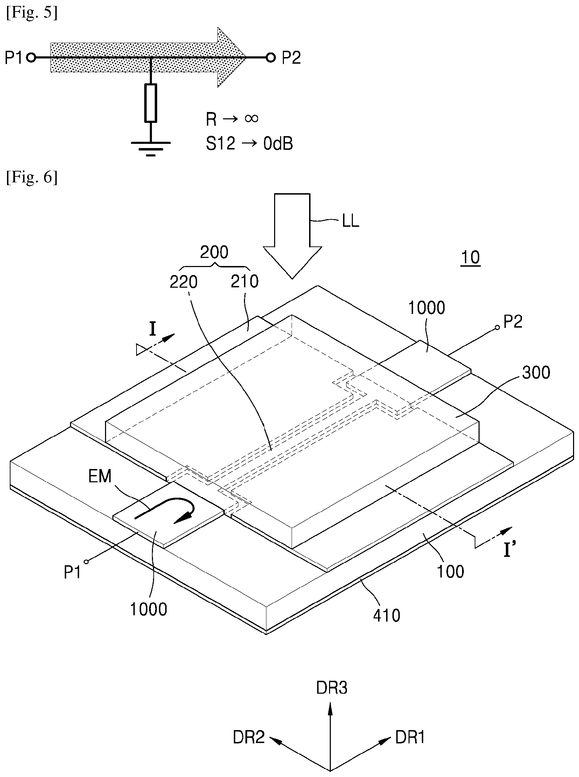

FIG. 3 illustrates an OFF state of the high frequency switch 10 of FIGS. 1, 2A and 2B. FIG. 4 is a cross-sectional view taken along line I-I' of FIG. 3. FIG. 5 is an equivalent circuit of FIG. 3.

Referring to FIGS. 3 and 4, the high frequency switch 10 may be in the OFF state. The photoconductive semiconductor element 300 may be in the dielectric state. The center conductor 220 and the pair of ground sections 210 may be electrically disconnected from each other by the photoconductive semiconductor element 300. The pair of signal transmission lines 1000 and the high frequency switch 10 may impedance match each other. Accordingly, when the high frequency switch 10 is in the OFF state, electromagnetic (EM) waves may propagate through the high frequency switch 10 with minimal loss, and electric fields (EF) may be formed between the center conductor 220 and the pair of ground sections 210.

Referring to FIG. 5, the electromagnetic waves EM of FIG. 3 may propagate from the first port P1 to the second port P2 through the high frequency switch 10 of FIG. 3. A transmission factor S12 between the first port P1 and the second port P2 may be 0 dB and may indicate loss of EM's when the EM's propagate from the first port P1 to the second port P2. The parallel resistance R may have a very large value. For example, the parallel resistance R may have a value close to infinity(∞).

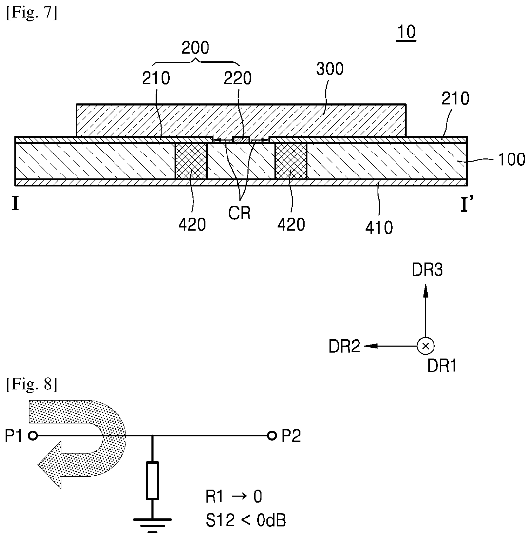

FIG. 6 illustrates an ON state of the high frequency switch 10 of FIGS. 1, 2A and 2B. FIG. 7 is a cross-sectional view taken along line I-I' of FIG. 6. FIG. 8 is an equivalent circuit of FIG. 6.

Referring to FIGS. 6 and 7, control light (LL) may be irradiated on the photoconductive semiconductor element 300 by being provided from the outside of the photoconductive semiconductor element 300. Accordingly, the photoconductive semiconductor element 300 may have a conductive state. The center conductor 220 and the pair of ground sections 210 may be electrically connected to each other by the photoconductive semiconductor element 300. When the EM's propagate from the first port P1 to the high frequency switch 10, a current (CR) may pass through the photoconductive semiconductor element 300 between the center conductor 220 and the pair of ground sections 210. Accordingly, a forward wave propagation condition of the high frequency switch 10 may be broken and a reverse wave propagation condition (i.e., a reflection condition) of the high frequency switch 10 may be created. As a result, the EM's may be reflected by the high frequency switch 10. Supply/bias circuits of the high frequency switch 10 may be separated from an RF wave path. The degree of reflection may be adjusted by control light power.

Each of the photoconductive semiconductor elements 300 between the center conductor 220 and the pair of ground sections 210 may be identical to a parallel resistor for which resistance is calculated by Equation (1), as follows.

$$R \doteq L/(\sigma S) \ \ldots\ldots(1)$$

In Equation (1), R denotes resistance of a parallel resistor, $\sigma$ denotes conductivity of a photoconductive semiconductor element under control light, L denotes a length of a region through which a current passes (i.e., a width of a gap or distance between the center conductor 220 and the pair of ground sections 210), and S denotes a sectional area of a region through which a current passed along planar waveguide line.

The current CR may flow from the center conductor 220 to the pair of ground sections 210 in the coplanar waveguide line 200. The sectional area S of the region through which the current CR passed along the coplanar waveguide line 200 may be a product of multiplying the length of the center conductor 220 and the thickness of the center conductor 220. The sectional area S of the region through which the current CR passed through along the coplanar waveguide line 200 may depend on the length of the center conductor 220. When combined resistance by the photoconductive semiconductor elements 300 between the center conductor 220 and the pair of ground sections 210 is minimal, blocking performance of the high frequency switch 10 may be high, and therefore, may be defined by the length of the center conductor 220.

Referring to FIG. 8, the equivalent circuit of the photoconductive semiconductor element 300 in the ON state is shown. The EM's propagated to the high frequency switch from the first port P1 may be reflected by the high frequency switch. The transmission factor S12 between the first port P1 and the second port P2 may be less than 0 dB. The parallel resistance R1 may have a value close to zero.

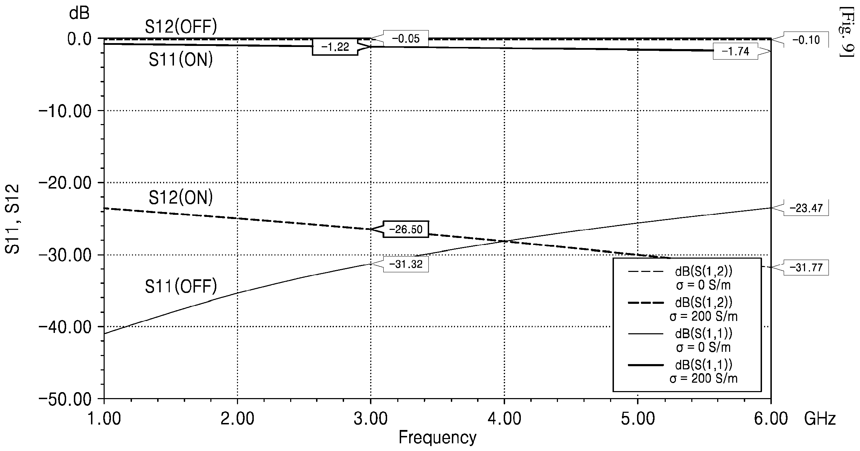

FIG. 9 illustrates a simulation result regarding the ON state and the OFF state of the high frequency switch 10 of FIGS. 1, 2A and 2B.

Referring to FIG. 9, transmission factors S12 and reflection factors S11 according to the ON state and the OFF state of the high frequency switch 10 described with reference to FIGS. 1, 2A and 2B are shown. The transmission factors S12 indicate loss of the EM's when the high frequency switch 10 is in the OFF state. The reflection factors S11 indicate loss of the EM's when the high frequency switch 10 has the ON state. Dashed lines indicate the transmission factors S12 and solid lines indicate the reflection factors S11.

When the high frequency switch 10 is in the ON state (i.e., when control light is irradiated on the photoconductive semiconductor element 300), the conductivity of the photoconductive semiconductor element 300 is 200 S/m, and a significant part of signal power is reflected. At a signal frequency of 6 GHz, loss of a transmitted signal is over 31 dB and loss of a reflected signal is 1.74 dB.

When the high frequency switch 10 is in the OFF state (i.e., when there is no control light), the conductivity of the photoconductive semiconductor element 300 is 0 S/m, and most of signal power is transmitted from the first port P1 to the second port P2. At the signal frequency of 6 GHz, the loss of the transmitted signal is 0.1 dB and the loss of the reflected signal is 23 dB.

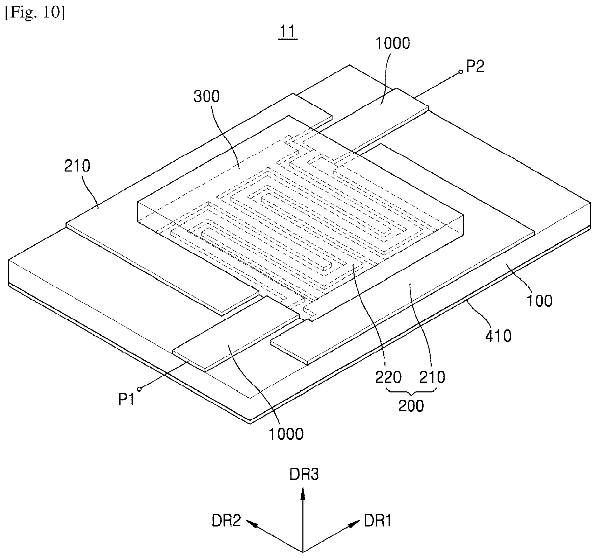

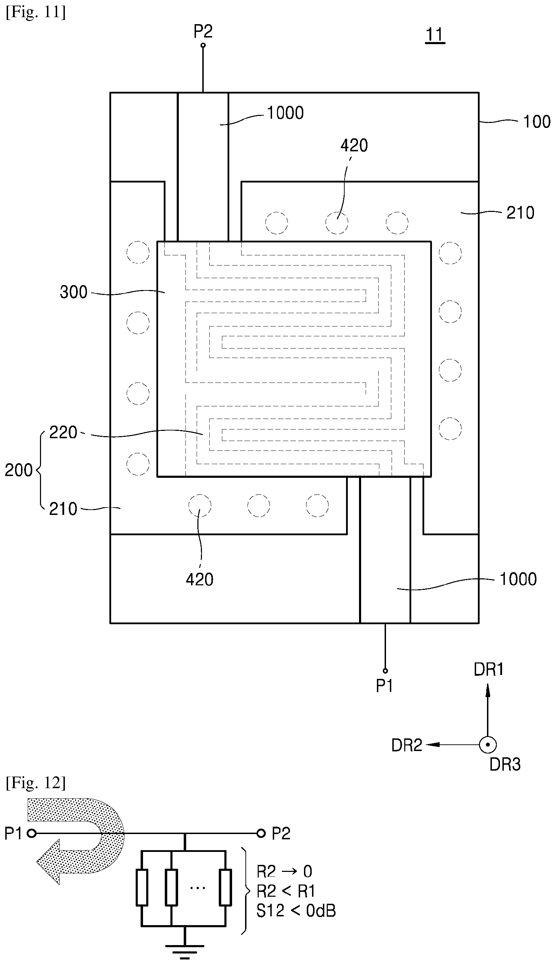

FIG. 10 illustrates a high frequency switch 11 according to an embodiment. FIG. 11 is a plan view of FIG. 10. FIG. 12 is an equivalent circuit of the high frequency switch 11 in an ON state. For conciseness, descriptions that are similar to those of FIGS. 1, 2A and 2B are not repeated.

Unlike in FIGS. 1 and 2A, referring to FIGS. 10 and 11, the center conductor 220 may be non-linear, such as having a winding shape. A length of the non-linear center conductor 220 may be longer than the length of the linear center conductor 220.

The pair of ground sections 210 may have a shape corresponding to the center conductor 220 such that the distances between the center conductor 220 and the pair of ground sections 210 are uniform.

The regions between the center conductor 220 and the pair of ground sections 210 may be longer when the center conductor 220 is non-linear than when the center conductor 220 is linear. Accordingly, the photoconductive semiconductor element 300 provided between the center conductor 220 and the pair of ground sections 210 may also be longer when the center conductor 220 is non-linear than when the center conductor 220 is linear. When the lengths of the pair of ground sections 210 are increased, the combined resistance by the photoconductive semiconductor elements between the center conductor 220 and the pair of ground sections 210 may be decreased, thereby improving blocking performance of the high frequency switch 11.

FIG. 12 illustrates the equivalent circuit of the high frequency switch in the ON state. Electromagnetic waves propagated from the first port P1 to the high frequency switch may be reflected by the high frequency switch. The transmission factor S12 between the first port P1 and the second port P2 may be less than 0 dB. A parallel resistance R2 may be the equivalent resistance of sub-parallel resistances R1 connected in parallel. The parallel resistance R2 may be smaller than the sub-parallel resistance R1. The parallel resistance R2 may have a value close to zero.

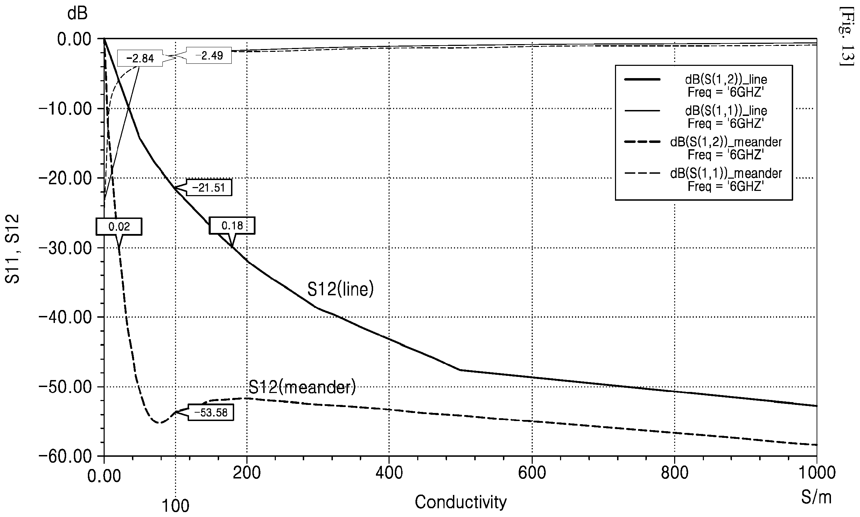

FIG. 13 illustrates the simulation results of the operations of the high frequency switches 10 and 11.

Referring to FIG. 13, the comparison graph of the transmission factors S12 and the reflection factors S11 of the high frequency switch 10 described with reference to FIGS. 1, 2A and 2B and the high frequency switch 11 described with reference to FIGS. 10 and 11 is shown. The center conductor 220 described with reference to FIGS. 10 and 11 (hereinafter, referred to as the non-linear center conductor 220) may be longer than the center conductor 220 described with reference to FIGS. 1, 2A and 2B (hereinafter, referred to as the linear center conductor 220). For example, the non-linear center conductor 220 may have a winding shape that may extend in the first direction DR1.

Dashed lines relate to the operation of the high frequency switch 11 including the non-linear center conductor 220 and solid lines relate to the operation of the high frequency switch 10 including the linear center conductor 220. When the signal frequency is 6 GHz and the conductivity of the photoconductive semiconductor element 300 is 100 S/m, the transmission factor S12 of the high frequency switch 11 in the ON state including the non-linear center conductor 220 is about -21 dB. When the signal frequency is 6 GHz and the photoconductive semiconductor element 300 is 100 S/m, the transmission factor S12 of the high frequency switch 10 in the ON state including the linear center conductor 220 is about -53 dB or more. The high frequency switch 11 in the ON state including the non-linear center conductor 220 has improved blocking performance than the high frequency switch 10 in the ON state including the linear center conductor 220.

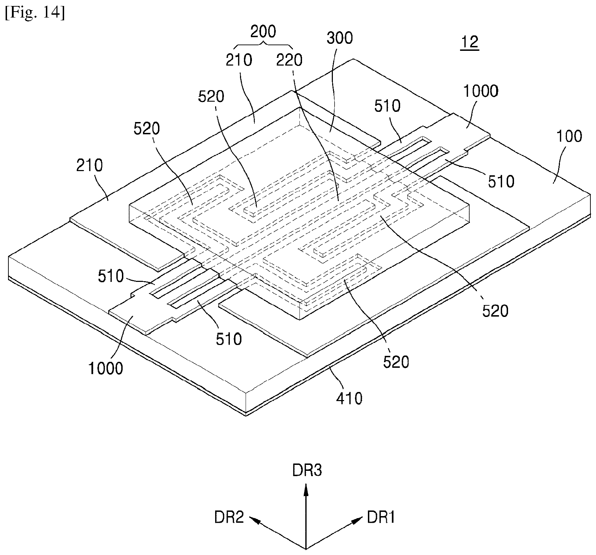

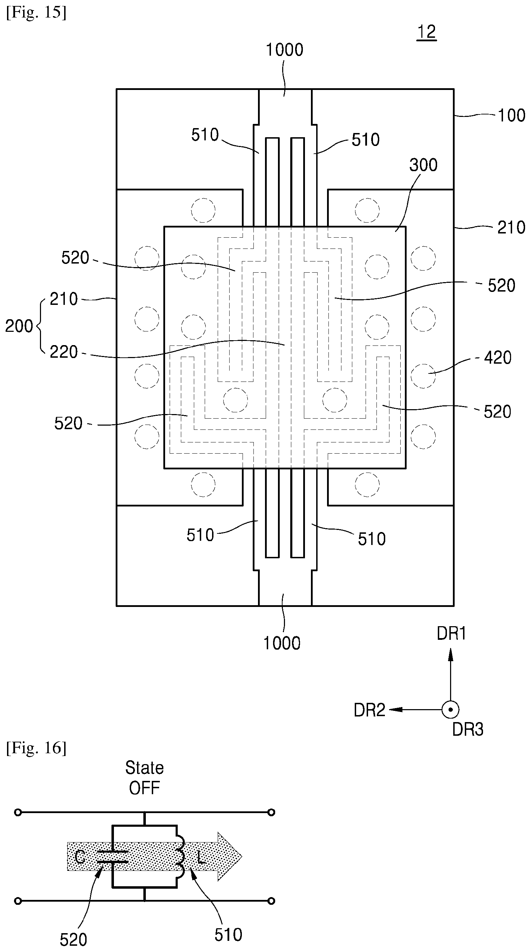

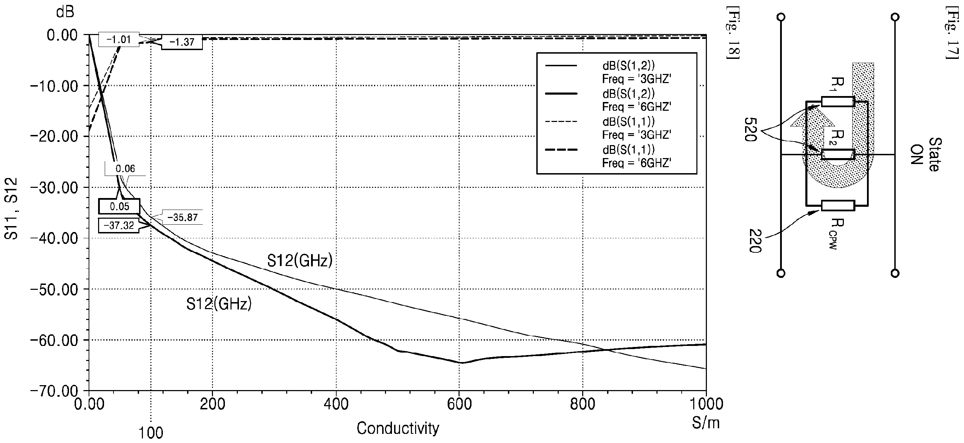

FIG. 14 illustrates a high frequency switch 12 according to an embodiment. FIG. 15 is a plan view of FIG. 14. FIG. 16 is an equivalent circuit of the high frequency switch 12 of FIG. 14 in an OFF state. FIG. 17 is an equivalent circuit of the high frequency switch 12 of FIG. 14 in an ON state. FIG. 18 illustrates simulation results of operations of the high frequency switch 12 according to frequencies. For conciseness, descriptions that are similar to those of FIGS. 1, 2A and 2B may not be repeated.

Unlike FIGS. 1, 2A and 2B, referring to FIGS. 14 and 15, the high frequency switch 12 further includes matching inductance elements 510 and capacitive stubs 520, which are connected to the center conductor 220 in parallel. The capacitive stubs 520 respectively extend from the matching inductance elements 510.

The photoconductive semiconductor elements 300 may extend and fill regions between the center conductor 220, the pair of ground sections 210, and the capacitive stubs 520, and may contact the substrate 100 between the center conductor 220, the pair of ground sections 210, and the capacitive stubs 520.

Referring to FIG. 16, the equivalent circuit of the high frequency switch 12 in the OFF state is shown. The matching inductance 510 and the capacitive stub 520 respectively have functions of an inductor and a capacitor with respect to a high frequency current, and are impedance-matched to each other and form a resonance structure. The matching inductance elements 510 and the capacitive stubs 520 do not affect propagation of electromagnetic waves in some frequency bands. When the high frequency switch 12 is in the OFF state, the electromagnetic waves propagate with minimal loss.

Referring to FIG. 17, the equivalent circuit of the high frequency switch 12 in the ON state is shown. When control light is irradiated on the photoconductive semiconductor element 300, the photoconductive semiconductor element 300 may become conductive. The center conductor 220 and the capacitive stubs 520 may be electrically connected to the pair of ground sections 210 by the photoconductive semiconductor element 300, and may have parallel resistance. Accordingly, combined resistance of the high frequency switch 12 may be decreased, thereby resulting in improved blocking performance of the high frequency switch 12.

Referring to FIG. 18, the transmission factors S12 and the reflection factors S11 with respect to a 3 GHz signal and a 6 GHz signal are provided. The transmission factor S12 with respect to the 3 GHz signal is shown in a thin solid line, and the transmission factor S12 with respect to the 6 GHz signal is shown in a thick solid line. The reflection factor S11 with respect to the 3 GHz signal is shown in a thin dashed line, and the reflection factor S11 with respect to the 6 GHz signal is shown in a thick dashed line. When the conductivity of the photoconductive semiconductor element 300 is 100 S/m, the transmission factor S12 with respect to the 6 GHz signal is about -37 dB, and the transmission factor S12 with respect to the 3 GHz signal is about -36 dB. The transmission factor S12 of the high frequency switch 12 described with reference to FIGS. 1, 2A and 2B may be about -22 dB with respect to the 6 GHz signal when the conductivity of the photoconductive semiconductor element 300 is 100 S/m (see FIG. 13). The blocking performance of the high frequency switch 12 of this embodiment is greater than that of the high frequency switch 10 described with reference to FIGS. 1, 2A and 2B.

When the conductivity of the photoconductive semiconductor element 300 is 100 S/ m, the reflection factor S11 of the high frequency switch 12 may be about -1 dB with respect to the 3 GHz and 6 GHz signals. The reflection factor S11 of the high frequency switch 10 described with reference to FIGS. 1, 2A and 2B may be about -3 dB with respect to the 6 GHz signal when the conductivity of the photoconductive semiconductor element 300 is 100 S/m (see FIG. 13). The reflection loss of the high frequency switch 12 of this embodiment is less than that of the high frequency switch 10 described with reference to FIGS. 1, 2A and 2B.

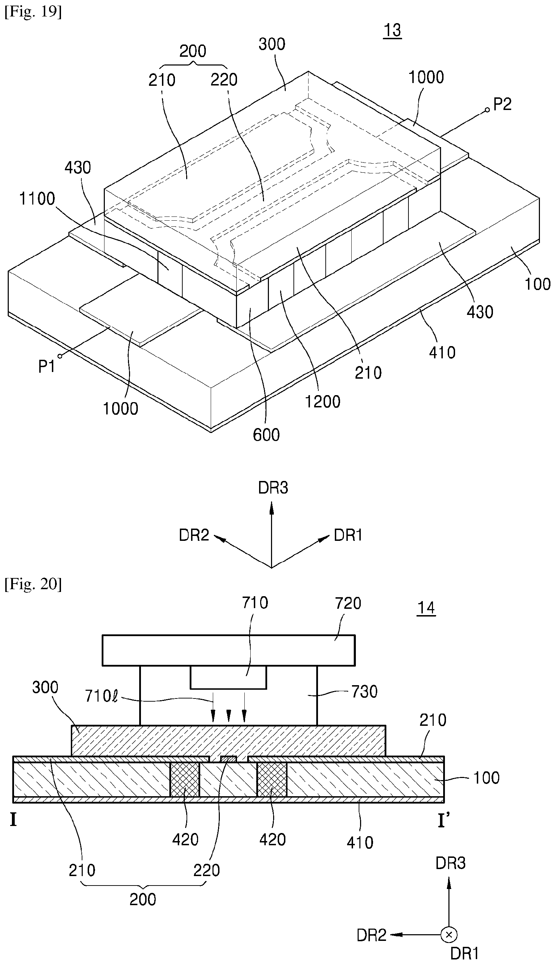

FIG. 19 illustrates a high frequency switch 13 according to an embodiment. For conciseness, descriptions that are similar to those of FIGS. 1, 2A and 2B may not be repeated.

Referring to FIG. 19, the high frequency switch 13 may include the substrate 100, a pair of ground electrodes 430, the bottom ground layer 410, a dielectric layer 600, the coplanar waveguide line 200, first top contacts 1200, second top contacts 1100, and the photoconductive semiconductor element 300. The substrate 100 and the bottom ground layer 410 may be similar to those described with reference to FIGS. 1, 2A and 2B. The pair of ground electrodes 430 may be provided between the substrate 100 and the dielectric layer 600. The pair of ground electrodes 430 may be electrically connected to the bottom ground layer 410 by vias that may be similar to those described with reference to FIGS .1, 2A and 2B.

The dielectric layer 600 may be provided on the substrate 100, and although illustrated to cover a part of the substrate 100, the dielectric layer 600 may entirely cover the substrate 100 as an alternative.

The coplanar waveguide line 200 may be provided on the dielectric layer 600 and may include the pair of ground sections 210 and the center conductor 220. The photoconductive semiconductor element 300 may be provided on the coplanar waveguide line 200. The coplanar waveguide line 200 and the photoconductive semiconductor element 300 may be similar to those described with reference to FIGS. 1, 2A and 2B.

The first top contacts 1200 may be provided between the pair of ground sections 210 and the pair of ground electrodes 430 and may electrically connect the pair of ground sections 210 and the pair of ground electrodes 430 to each other. For example, the first top contacts 1200 may directly contact the pair of ground sections 210 and the pair of ground electrodes 430 and may include a conductive material, such as Cu.

The pair of signal transmission lines 1000 may be provided on the substrate 100 between the substrate 100 and the dielectric layer 600, and may be similar to those described with reference to FIGS. 1, 2A and 2B.

The second top contacts 1100 may be provided between the pair of signal transmission lines 1000 and both end portions of the center conductor 220, and may electrically connect the pair of signal transmission lines 1000 and the both end portions of the center conductor 220 to each other. For example, the second top contacts 1100 may directly contact the pair of signal transmission lines 1000 and the both end portions of the center conductor 220, and may include a conductive material, such as Cu.

FIG. 20 is a cross-sectional view of a high frequency switch 14 according to an embodiment, which corresponds to line I-I' of FIG. 1. For conciseness, descriptions that are similar to those of FIGS. 1, 2A and 2B may not be repeated.

Referring to FIG. 20, the high frequency switch 14 including the substrate 100, the coplanar waveguide line 200, the photoconductive semiconductor element 300, the bottom ground layer 410, the vias 420, a light source 710, a controller 720, and a spacer 730 is provided. The substrate 100, the coplanar waveguide line 200, the photoconductive semiconductor element 300, the bottom ground layer 410, and the vias 420 may be similar to those described with reference to FIGS. 1, 2A and 2B.

The light source 710 may emit control light 7101 to the photoconductive semiconductor element 300. For example, the light source 710 may include at least one of a light emitting diode (LED), a laser, or a laser diode. A working wavelength of the light source 710 (i.e., a wavelength of the control light 7101) may be selected based on absorption capability of the photoconductive semiconductor element 300. For example, the working wavelength of the light source 710 may be materially identical to a maximum absorption wavelength of the photoconductive semiconductor element 300. When the photoconductive semiconductor element 300 includes Si, the photoconductive semiconductor element 300 may have the maximum absorption wavelength at a near infrared ray (IR) range, such as about 940 nm. The light source 710 may be controlled by the controller 720. When the high frequency switch 14 is in the OFF state, the controller 720 may control the light source 710 not to emit the control light 7101. When the high frequency switch 14 is in the ON state, the controller 720 may control the light source 710 to emit the control light 7101. The controller 720 may include a PCB on which a control circuit is mounted.

The spacer 730 may uniformly maintain a distance between the photoconductive semiconductor element 300 and the light source 710 and may include a transparent dielectric material.

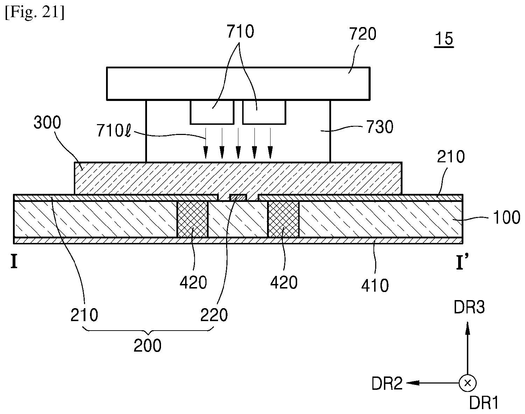

FIG. 21 is a cross-sectional view of a high frequency switch 15 according to an embodiment, which corresponds to line I-I' of FIG. 1. For conciseness, descriptions that are similar to those described with reference to FIGS. 1, 2A and 2B and 20 may not be repeated.

Referring to FIG. 21, the high frequency switch 15 may include the substrate 100, the coplanar waveguide line 200, the photoconductive semiconductor element 300, the bottom ground layer 410, the vias 420, a plurality of light sources 710, the controller 720, and the spacer 730. The substrate 100, the coplanar waveguide line 200, the photoconductive semiconductor element 300, the bottom ground layer 410, and the vias 420 may be similar to those described with reference to FIGS. 1, 2A and 2B.

Unlike FIG. 20, the plurality of the light sources 710 may be provided in FIG. 21. The control light 7101 emitted from the plurality of light sources 710 may be irradiated on a wider area of the photoconductive semiconductor element 300 than control light emitted from one light source. Accordingly, conductive distribution of the photoconductive semiconductor element 300 irradiated by the control light 7101 emitted from the plurality of light sources 710 may be more uniform than conductive distribution of the photoconductive semiconductor element 300 irradiated by the control light 7101 emitted from one light source 710.

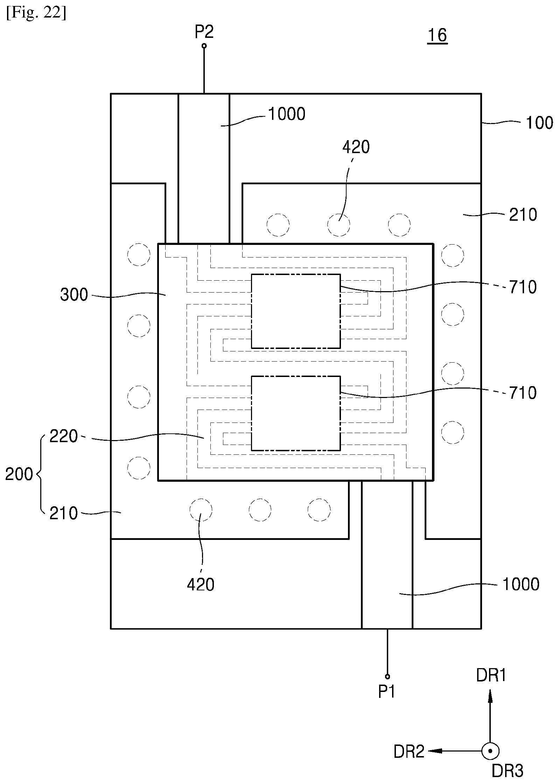

FIG. 22 is a plan view of a high frequency switch 16 according to an embodiment. For conciseness, descriptions that are similar to those described with reference to FIGS. 10, 11, and 20 may not be repeated.

Referring to FIG. 22, the high frequency switch 16 may include the substrate 100, the coplanar waveguide line 200, the photoconductive semiconductor element 300, and the pair of light sources 710. The substrate 100, the coplanar waveguide line 200, and the photoconductive semiconductor element 300 may be similar to those described with reference to FIGS. 10 and 11.

Unlike FIG. 20, the pair of light sources 710 may be provided. The control light 7101 emitted from the pair of light sources 710 may be irradiated on a wider area of the photoconductive semiconductor element 300 than control light emitted from one light source. Accordingly, conductive distribution of the photoconductive semiconductor element 300 irradiated by the control light 7101 emitted from the pair of light sources 710 may be more uniform than conductive distribution of the photoconductive semiconductor element 300 irradiated by the control light 7101 emitted from one light source 710.

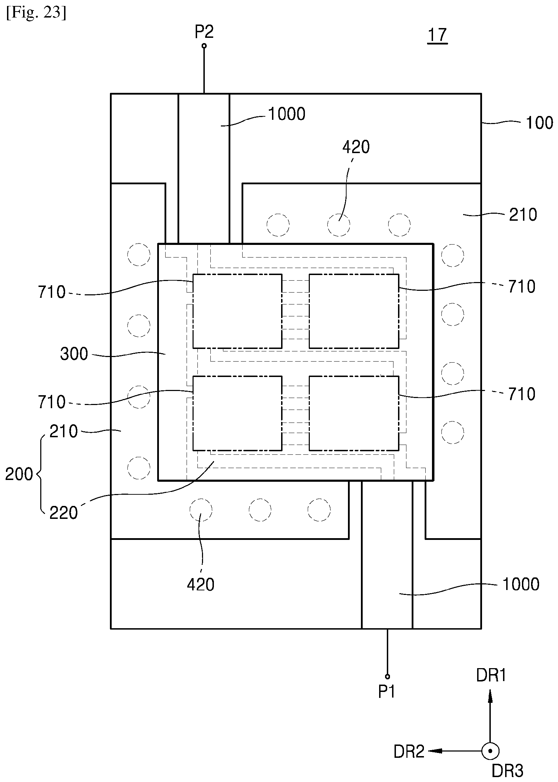

FIG. 23 is a plan view of a high frequency switch 17 according to an embodiment. For conciseness, descriptions that are materially identical as those described with reference to FIGS. 10, 11, and 20 may not be repeated.

Referring to FIG. 23, the high frequency switch 17 may include the substrate 100, the coplanar waveguide line 200, the photoconductive semiconductor element 300, and a plurality of light sources 710. The substrate 100, the coplanar waveguide line 200, and the photoconductive semiconductor element 300 may be similar to those described with reference to FIGS. 10 and 11.

Unlike FIG. 20, the four light sources 710 may be provided. The control light 7101 emitted from the four light sources 710 may be irradiated on a wider area of the photoconductive semiconductor element 300 than control light emitted from one light source. Accordingly, conductive distribution of the photoconductive semiconductor element 300 irradiated by the control light 7101 emitted from the four light sources 710 may be more uniform than conductive distribution of the photoconductive semiconductor element 300 irradiated by the control light 7101 emitted from one light source 710.

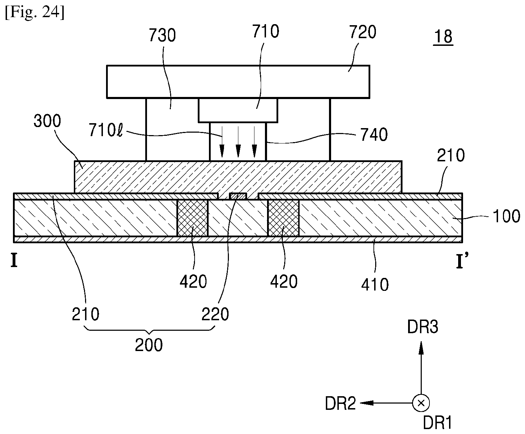

FIG. 24 is a cross-sectional view of a high frequency switch 18 according to an embodiment, which corresponds to line I-I' of FIG. 1. For conciseness, descriptions that are similar to those described with reference to FIGS. 1, 2A and 2B and 20 may not be repeated.

Referring to FIG. 24, the high frequency switch 18 may include the substrate 100, the coplanar waveguide line 200, the photoconductive semiconductor element 300, the bottom ground layer 410, the vias 420, the light source 710, the controller 720, and the spacer 730. The substrate 100, the coplanar waveguide line 200, the photoconductive semiconductor element 300, the bottom ground layer 410, and the vias 420 may be similar to those described with reference to FIGS. 1, 2A and 2B.

Unlike FIG. 20, referring to FIG. 24, the high frequency switch 18 may further include an optical fiber 740. The control light 7101 emitted from the light source 710 may reach the photoconductive semiconductor element 300 through the optical fiber 740. According to an embodiment, the high frequency switch 18 may include an optical waveguide instead of the optical fiber 740.

While the present disclosure has been shown and described with reference to certain embodiments thereof, it will be understood by those skilled in the art that various changes in form and details may be made therein without departing from the scope of the disclosure as defined by the appended claims.

**Claims**

1. A high frequency switch (10) comprising:

   a substrate (100);
   a pair of ground sections (210) provided on the substrate;
   a center conductor (220) provided between the pair of ground sections;
   a photoconductive semiconductor element (300) provided on the center conductor and extending between the center conductor and the pair of ground sections;
   **characterized in that** the high frequency switch further comprises a plurality of capacitive stubs (520); and
   a plurality of matching inductance elements (510),
   wherein the plurality of capacitive stubs and the plurality of matching inductance elements are impedance-matched to each other.

2. The high frequency switch of claim 1, wherein the photoconductive semiconductor element (300) fills regions between the center conductor (220) and the pair of ground sections (210).

3. The high frequency switch (10) of claim 1 or 2, wherein the center conductor (220) has a line shape extending in one direction parallel to a top surface of the substrate (100).

4. The high frequency switch (10) of any one of claims 1 to 3, further comprising:

   a bottom ground layer (410) covering a bottom surface of the substrate (100); and
   a plurality of vias (420) electrically connecting the bottom ground layer and the pair of ground sections (210) to each other, wherein the plurality of vias penetrate the substrate.

5. The high frequency switch (10) of any one of claims 1 to 4, wherein the center conductor (220) extends non-linearly.

**6.** The high frequency switch (10) of any one of claims 1 to 5, further comprising a pair of signal transmission lines (1000) provided on the substrate (100),

wherein the pair of signal transmission lines are respectively electrically connected to both end portions of the center conductor (220), and wherein a width of each of the pair of signal transmission lines is greater than a width of the center conductor.

**7.** The high frequency switch (10) of claim 1, further comprising a light source (710) configured to irradiate control light (710l) on the photoconductive semiconductor element (300).

**8.** The high frequency switch (10) of claim 7, wherein the light source (710) is provided on the photoconductive semiconductor element (300).

**9.** The high frequency switch (10) of claim 7 or 8, wherein the light source (710) comprises a plurality of light sources.

**10.** The high frequency switch (10) of any one of claims 7 to 9, further comprising an optical fiber (740) provided between the light source (710) and the photoconductive semiconductor element (300), wherein the optical fiber is configured to transmit the control light (710l) to the photoconductive semiconductor element.

**11.** The high frequency switch (10) of claim 1,

wherein the pair of ground sections (210) and the center conductor (220) comprise a coplanar waveguide line (200) provided between the substrate (100) and the photoconductive semiconductor element (300),

wherein the high frequency switch is configured to reflect electromagnetic waves propagated to the coplanar waveguide line in response to control light (710l) being irradiated on the photoconductive semiconductor element, and

wherein the high frequency switch is configured to allow transmission of the electromagnetic waves through the high frequency switch in response to the control light being blocked from being irradiated on the photoconductive semiconductor element.

**12.** The high frequency switch (10) of claim 11, further comprising a light source (710) configured to irradiate the control light (710l) on the photoconductive semiconductor element (300).

**13.** The high frequency switch (10) of claim 12, wherein the light source (710) is configured to emit the control light (710l) having a wavelength band comprising a maximum absorption wavelength of the photoconductive semiconductor element (300).

**Patentansprüche**

**1.** Hochfrequenzschalter (10), umfassend:

ein Substrat (100);
ein Paar Masseabschnitte (210), die auf dem Substrat bereitgestellt sind;
einen Mittelleiter (220), der zwischen dem Paar Masseabschnitte bereitgestellt ist;
ein photoleitfähiges Halbleiterelement (300), das auf dem Mittelleiter bereitgestellt ist und sich zwischen dem Mittelleiter und dem Paar Masseabschnitte erstreckt;
**dadurch gekennzeichnet, dass** der Hochfrequenzschalter ferner umfasst
eine Vielzahl von kapazitiven Stichleitungen (520); und
eine Vielzahl von Anpassungsinduktanzelementen (510),
wobei die Vielzahl von kapazitiven Stichleitungen und die Vielzahl von Anpassungsinduktanzelementen aneinander impedanzangepasst sind.

**2.** Hochfrequenzschalter nach Anspruch 1, wobei das photoleitfähige Halbleiterelement (300) Bereiche zwischen dem Mittelleiter (220) und dem Paar Masseabschnitte (210) füllt.

**3.** Hochfrequenzschalter (10) nach Anspruch 1 oder 2, wobei der Mittelleiter (220) eine Leitungsform aufweist, die sich in einer Richtung parallel zu einer oberen Oberfläche des Substrats (100) erstreckt.

**4.** Hochfrequenzschalter (10) nach einem der Ansprüche 1 bis 3, ferner umfassend:

eine untere Masseschicht (410), die eine untere Oberfläche des Substrats (100) bedeckt; und
eine Vielzahl von Durchkontaktierungen (420), die die untere Masseschicht und das Paar Masseabschnitte (210) elektrisch miteinander verbinden, wobei die Vielzahl von Durchkontaktierungen das Substrat durchdringen.

**5.** Hochfrequenzschalter (10) nach einem der Ansprüche 1 bis 4, wobei sich der Mittelleiter (220) nicht linear erstreckt.

**6.** Hochfrequenzschalter (10) nach einem der Ansprüche 1 bis 5, ferner umfassend ein Paar Signalübertragungsleitungen (1000), die auf dem Substrat (100) bereitgestellt sind,

wobei das Paar Signalübertragungsleitungen jeweils elektrisch mit beiden Endstücken des Mittelleiters (220) verbunden sind und
wobei eine Breite jeder von dem Paar Signalübertragungsleitungen größer als eine Breite des Mittelleiters ist.

7.  Hochfrequenzschalter (10) nach Anspruch 1, ferner umfassend eine Lichtquelle (710), die dazu konfiguriert ist, Steuerlicht (710l) auf das photoleitfähige Halbleiterelement (300) zu strahlen.

8.  Hochfrequenzschalter (10) nach Anspruch 7, wobei die Lichtquelle (710) auf dem photoleitfähigen Halbleiterelement (300) bereitgestellt ist.

9.  Hochfrequenzschalter (10) nach Anspruch 7 oder 8, wobei die Lichtquelle (710) eine Vielzahl von Lichtquellen umfasst.

10. Hochfrequenzschalter (10) nach einem der Ansprüche 7 bis 9, ferner umfassend eine optische Faser (740), die zwischen der Lichtquelle (710) und dem photoleitfähigen Halbleiterelement (300) bereitgestellt ist, wobei die optische Faser dazu konfiguriert ist, das Steuerlicht (710l) zu dem photoleitfähigen Halbleiterelement zu übertragen .

11. Hochfrequenzschalter (10) nach Anspruch 1,

wobei das Paar Masseabschnitte (210) und der Mittelleiter (220) eine koplanare Wellenleiterleitung (200) umfassen, die zwischen dem Substrat (100) und dem photoleitfähigen Halbleiterelement (300) bereitgestellt ist,
wobei der Hochfrequenzschalter dazu konfiguriert ist, elektromagnetische Wellen zu reflektieren, die sich zu der koplanaren Wellenleiterleitung als Reaktion darauf, dass Steuerlicht (710l) auf das photoleitfähige Halbleiterelement gestrahlt wird, ausbreiten, und
wobei der Hochfrequenzschalter dazu konfiguriert ist, eine Übertragung der elektromagnetischen Wellen durch den Hochfrequenzschalter als Reaktion darauf zu ermöglichen, dass das Steuerlicht daran gehindert wird, auf das photoleitende Halbleiterelement gestrahlt zu werden.

12. Hochfrequenzschalter (10) nach Anspruch 11, ferner umfassend eine Lichtquelle (710), die dazu konfiguriert ist, das Steuerlicht (710l) auf das photoleitfähige Halbleiterelement (300) zu strahlen.

13. Hochfrequenzschalter (10) nach Anspruch 12, wobei die Lichtquelle (710) dazu konfiguriert ist, das Steuerlicht (710l) mit einem Wellenlängenband zu emittieren, das eine maximale Absorptionswellenlänge des photoleitfähigen Halbleiterelements (300) umfasst.

## Revendications

1.  Commutateur haute fréquence (10) comprenant :

un substrat (100) ;
une paire de sections de mise à la terre (210) disposées sur le substrat ;
un conducteur central (220) disposé entre la paire de sections de mise à la terre ;
un élément semi-conducteur photoconducteur (300) disposé sur le conducteur central et s'étendant entre le conducteur central et la paire de sections de mise à la terre ;
**caractérisé en ce que** le commutateur haute fréquence comprend en outre
une pluralité de bras capacitifs (520) ; et
une pluralité d'éléments d'inductance correspondant (510),
ladite pluralité de bras capacitifs et la pluralité d'éléments d'inductance correspondants étant mis en correspondance suivant leurs impédances les uns avec les autres.

2.  Commutateur haute fréquence selon la revendication 1, ledit élément semi-conducteur photoconducteur (300) remplissant des zones entre le conducteur central (220) et la paire de sections de mise à la terre (210).

3.  Commutateur haute fréquence (10) selon la revendication 1 ou 2, ledit conducteur central (220) possédant une forme de ligne s'étendant dans une direction parallèle à une surface supérieure du substrat (100).

4.  Commutateur haute fréquence (10) selon l'une quelconque des revendications 1 à 3, comprenant en outre :

une couche de mise à la terre inférieure (410) recouvrant une surface inférieure du substrat (100) ; et
une pluralité de vias (420) raccordant électriquement la couche de mise à la terre inférieure et la paire de sections de mise à la terre (210) l'une à l'autre, la pluralité de vias pénétrant dans le substrat.

5.  Commutateur haute fréquence (10) selon l'une quelconque des revendications 1 à 4, ledit conducteur central (220) s'étendant de manière non linéaire.

6.  Commutateur haute fréquence (10) selon l'une quelconque des revendications 1 à 5, comprenant en outre une paire de lignes d'émission de signal (1000) disposées sur le substrat (100),

ladite paire de lignes d'émission de signal étant respectivement raccordée électriquement aux deux parties d'extrémité du conducteur central (220), et
une largeur de chacune de la paire de lignes de transmission de signal étant supérieure à une largeur du conducteur central.

7. Commutateur haute fréquence (10) selon la revendication 1, comprenant en outre une source de lumière (710) conçue pour rayonner une lumière de commande (710l) sur l'élément semi-conducteur photoconducteur (300).

8. Commutateur haute fréquence (10) selon la revendication 7, ladite source de lumière (710) étant disposée sur l'élément semi-conducteur photoconducteur (300).

9. Commutateur haute fréquence (10) selon la revendication 7 ou 8, ladite source de lumière (710) comprenant une pluralité de sources de lumière.

10. Commutateur haute fréquence (10) selon l'une quelconque des revendications 7 à 9, comprenant en outre une fibre optique (740) disposée entre la source de lumière (710) et l'élément semi-conducteur photoconducteur (300), ladite fibre optique étant conçue pour émettre la lumière de commande (710l) à l'élément semi-conducteur photoconducteur.

11. Commutateur haute fréquence (10) selon la revendication 1,

ladite paire de sections de mise à la terre (210) et ledit conducteur central (220) comprenant une ligne de guide d'ondes coplanaire (200) disposée entre le substrat (100) et l'élément semi-conducteur photoconducteur (300),
ledit commutateur haute fréquence étant conçu pour réfléchir les ondes électromagnétiques propagées vers la ligne de guide d'ondes coplanaire en réponse à la lumière de commande (710l) rayonnée sur l'élément semi-conducteur photoconducteur, et
ledit commutateur haute fréquence étant conçu pour permettre l'émission des ondes électromagnétiques à travers le commutateur haute fréquence en réponse au blocage du rayonnement de la lumière de commande sur l'élément semi-conducteur photoconducteur.

12. Commutateur haute fréquence (10) selon la revendication 11, comprenant en outre une source de lumière (710) conçue pour rayonner la lumière de commande (710l) sur l'élément semi-conducteur photoconducteur (300).

13. Commutateur haute fréquence (10) selon la revendication 12, ladite source de lumière (710) étant conçue pour émettre la lumière de commande (710l) possédant une bande de longueur d'onde comprenant une longueur d'onde d'absorption maximale de l'élément semi-conducteur photoconducteur (300).

[Fig. 1]

[Fig. 2a]

[Fig. 2b]

[Fig. 3]

[Fig. 4]

[Fig. 5]

$R \rightarrow \infty$
$S12 \rightarrow 0dB$

[Fig. 6]

[Fig. 7]

10

200
210    220    300    210

I    CR    I'

420    420    410

DR3

DR2    DR1

[Fig. 8]

P1    P2

R1 → 0
S12 < 0dB

[Fig. 9]

[Fig. 10]

[Fig. 11]

P2

1000

100

420

210

300

220

200

210

420

1000

P1

DR1

DR2

DR3

[Fig. 12]

P1

P2

$R2 \rightarrow 0$

$R2 < R1$

$S12 < 0dB$

[Fig. 13]

[Fig. 14]

[Fig. 15]

[Fig. 16]

[Fig. 17]

State
ON

R₁ R₂ R_CPW

520 220

[Fig. 18]

[Fig. 19]

DR3

DR2 ← → DR1

[Fig. 20]

DR3

DR2 ← ⊗ DR1

[Fig. 21]

[Fig. 22]

[Fig. 23]

[Fig. 24]

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **PANG ALEXANDER WEIRAN.** *An Optically Controlled Co-Planar Waveguide Millimetre Wave Switch*
- **FLEMISH J R.** *Optimization of a Photonically Controlled Microwave Switch and Attenuator*
- **AVANISH BHADAURIA.** *Optical Control of Microstrip Stub on Silicon Substrate Using 650 nm and 850 nm Wavelengths Illumination*